# EUROPEAN PATENT SPECIFICATION

(11) **EP 4 443 744 B1**
(45) Date of publication and mention of the grant of the patent: **25.11.2026**
(21) Application number: 22927171.3
(22) Date of filing: 21.02.2022
(51) Int. Cl.: H03F 1/02, H03F 3/68, H03F 1/32, H03F 3/189

(54) **AMPLIFIER AND SIGNAL DISTRIBUTION METHOD**
VERSTÄRKER UND SIGNALVERTEILUNGSVERFAHREN
AMPLIFICATEUR ET PROCÉDÉ DE DISTRIBUTION DE SIGNAL

(43) Date of publication of application: 09.10.2024
(73) Proprietor: MITSUBISHI ELECTRIC CORPORATION, Chiyoda-ku Tokyo 100-8310 (JP)
(72) Inventor: TORII, Takuma, Tokyo 100-8310 (JP); KOMATSUZAKI, Yuji, Tokyo 100-8310 (JP); YAMASHITA, Ao, Tokyo 100-8310 (JP)
(74) Representative: Pfenning, Meinig & Partner mbB
(86) International application number: PCT/JP2022/006817
(87) International publication number: WO 2023/157270

(56) References cited:
- WO-A1-2021/106033
- JP-A- 2014 003 490
- US-A1- 2012 294 387
- US-B2- 8 837 629
- KOMATSUZAKI YUJI ET AL: "A Novel 1.4-4.8 GHz Ultra-Wideband, over 45% High Efficiency Digitally Assisted Frequency-Periodic Load Modulated Amplifier", 1 June 2019 (2019-06-01), pages 706 - 709, XP093245015, ISBN: 978-1-7281-1309-8, Retrieved from the Internet <URL:https://ieeexplore.ieee.org/stampPDF/getPDF.jsp?tp=&arnumber=8700930&ref=aHR0cHM6Ly9pZWVleHBsb3JlLmllZWUub3JnL2RvY3VtZW50Lzg3MDA5MzA=> DOI: 10.1109/MWSYM.2019.8700930
- TORII TAKUMA ET AL: "A 1.2 to 5.7GHz Multi-Mode Dual-Input Power Amplifier Using a Novel Sigmoid-Function-Based Power Splitter", 2024 IEEE/MTT-S INTERNATIONAL MICROWAVE SYMPOSIUM - IMS 2024, IEEE, 16 June 2024 (2024-06-16), pages 481 - 484, XP034655177, DOI: 10.1109/IMS40175.2024.10600365

## Description

### TECHNICAL FIELD

The present disclosure relates to an amplifier and a signal distribution method of an amplifier.

### BACKGROUND ART

In recent years, with an increase in communication volume, an amplifier capable of amplifying a signal having a large peak-to-average power ratio (hereinafter referred to as "PAPR") with high efficiency is required as an amplifier for a mobile communication base station. Such an amplifier includes a Doherty amplifier or an out-phasing amplifier, and can operate with high efficiency at an operating point at which a back-off amount is large.

The Doherty amplifier or the out-phasing amplifier is a two-input amplifier that receives an input of a signal from each of two input terminals, amplifies the input signals, and outputs the amplified input signals from an output terminal. In the Doherty amplifier or the out-phasing amplifier, when an amplitude ratio and a phase difference between the two input signals are appropriately controlled, load modulation occurs, and a signal with a large PAPR can be amplified with high efficiency.

For example, a power amplifier system disclosed in JP 2002-124841 A includes a plurality of amplifier stages and a variable power divider, and an input signal is distributed to each of the plurality of amplifier stages by the variable power divider. Conventionally, a lookup table (hereinafter, simply referred to as an "LUT") in which appropriate amplitude ratio and phase difference corresponding to the amplitude of the input signal are registered is generally used to set the amplitude ratio and phase difference of the two input signals.

US 8 837 629 B2 discloses an extended bandwidth digital Doherty transmitter includes a baseband signal processing block including a digital predistortion unit. It also includes a digital signal distribution unit and a digital phase alignment unit, a signal up-conversion block, an RF power amplification block including the carrier amplifier and one or two peaking amplifiers; and an RF Doherty combining network. There is also an RF power amplification block including the carrier amplifier and two peaking amplifiers, and an RF Doherty combining network which includes quarter wavelength impedance transformers.

Komatsuzaki Yuji ET AL: "A Novel 1.4-4.8 GHz Ultra-Wideband, over 45% High Efficiency Digitally Assisted Frequency-Periodic Load Modulated Amplifier", 2019 IEEE MTT-S International Microwave Symposium (IMS), 1 June 2019 (2019-06-01), pages 706-709, XP093245015, DOI: 10.1109/MWSYM.2019.8700930 ISBN: 978-1-7281-1309-8, discloses an ultra-wideband and high efficiency sub-6GHz power amplifier, which is based on periodically varied load modulation with frequency. Key novelties are frequency periodic load modulation over multiple contiguous frequency bands combined with digitally assisted dual-input configuration, which provides optimum signal combination, magnitude and phase of dual-input signals.

### SUMMARY OF INVENTION

### TECHNICAL PROBLEM

In a case where the Doherty amplifier and the out-phasing amplifier are operated in a wide band in a plurality of bands, it is necessary to select information of appropriate amplitude ratio and phase difference between the two input signals depending on the amplitude of the input signal from the LUT and set the selected information in the amplifier.

However, the conventional amplifier has a problem that a scale of the LUT is larger as the operation frequency is wider or the number of operation bands is larger.

When the scale of the LUT is reduced, appropriate amplitude ratio and phase difference cannot be set, and performance of the amplifier is deteriorated.

The present disclosure solves the above-described problem, and an object thereof is to obtain an amplifier having a circuit configuration smaller than a circuit configuration using the LUT, the amplifier capable of being operated with high efficiency as the Doherty amplifier and the out-phasing amplifier, and a signal distribution method.

### SOLUTION TO PROBLEM

The above mentioned problems are solved by the amplifier and single distribution method of the amplifier according to the claims. The invention is set out in the appended set of claims. An amplifier according to the present disclosure is an amplifier including: a first amplifier element to amplify a first transmission signal obtained by up-converting a frequency of a first signal into a carrier frequency; a second amplifier element to amplify a second transmission signal obtained by up-converting a frequency of a second signal into a carrier frequency; and an output combination circuit to combine the amplified first transmission signal and the amplified second transmission signal to output, the amplifier including: a digital signal acquiring unit to acquire an input signal, which is a digital signal; a signal generation unit to generate an in-phase signal serving as a reference, an orthogonal signal serving as a reference, and an envelope signal serving as a reference by using the input signal; and a signal distribution unit to generate the first signal and the second signal by using the in-phase signal, the orthogonal signal, and the envelope signal, a differential value of a function representing either or both an amplitude ratio therebetween and a phase difference therebetween being continuous during transition of the envelope signal from a minimum value to a maximum value, wherein the function is a sigmoid function expressed by following formula: $f \left(x\right) = \left[a/\left\{{e}^{b \left(x-c\right)}+1\right\}\right] + d$ where f(x) is the sigmoid function, where a, b, c, and d represent coefficients, and where x is obtained by normalizing a magnitude |SigTx| of the envelope signal serving as a reference with a maximum value of |SigTx|.

### ADVANTAGEOUS EFFECTS OF INVENTION

According to the present disclosure, it is distributed into a first signal and a second signal, a differential value of a function representing either or both an amplitude ratio therebetween and a phase difference therebetween being continuous during transition of an envelope signal generated using an input signal from a minimum value to a maximum value, a first amplifier element amplifies a first transmission signal based on the first signal, a second amplifier element amplifies a second transmission signal based on the second signal, and the amplified first transmission signal and the amplified second transmission signal are combined to be output. As a result, the amplifier according to the present disclosure has a circuit configuration smaller than a circuit configuration using an LUT, and can be operated with high efficiency as a Doherty amplifier and an out-phasing amplifier.

### BRIEF DESCRIPTION OF DRAWINGS

FIG. 1 is a block diagram illustrating a configuration of an amplifier according to a first embodiment.
FIG. 2 is a flowchart illustrating a signal distribution method according to the first embodiment.
FIG. 3 is a characteristic diagram illustrating a relationship of an amplitude ratio and a phase difference between a first transmission signal and a second transmission signal with respect to magnitude of an envelope signal in a first Doherty operation mode.
FIG. 4 is a characteristic diagram illustrating a relationship of an amplitude ratio and a phase difference between a first transmission signal and a second transmission signal with respect to magnitude of an envelope signal in a second Doherty operation mode.
FIG. 5 is a characteristic diagram illustrating a relationship of an amplitude ratio and a phase difference between a first transmission signal and a second transmission signal with respect to magnitude of an envelope signal in a first out-phasing operation mode.
FIG. 6 is a characteristic diagram illustrating a relationship of an amplitude ratio and a phase difference between a first transmission signal and a second transmission signal with respect to magnitude of an envelope signal in a second out-phasing operation mode.
FIG. 7 is a diagram illustrating an example (1) of a sigmoid function.
FIG. 8 is a diagram illustrating an example (2) of the sigmoid function.
FIG. 9 is a diagram illustrating an example (3) of the sigmoid function.
FIG. 10 is a diagram illustrating an example (4) of the sigmoid function.
FIG. 11 is a block diagram illustrating a configuration of an amplifier according to a second embodiment.

### DESCRIPTION OF EMBODIMENTS

### First Embodiment

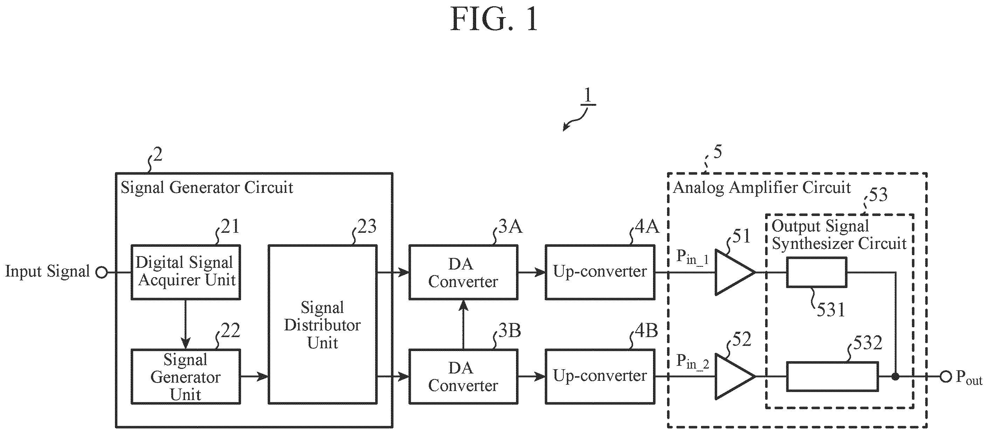

FIG. 1 is a block diagram illustrating a configuration of an amplifier 1 according to a first embodiment. In FIG. 1, the amplifier 1 distributes an input signal input from an input terminal into a first signal and a second signal, amplifies a first transmission signal Tₓ₁ obtained by up-converting a frequency of the first signal into a carrier frequency, amplifies a second transmission signal Tₓ₂ obtained by up-converting a frequency of the second signal into a carrier frequency, and outputs an output signal obtained by combining the first transmission signal Tₓ₁ and the second transmission signal Tₓ₂.

The amplifier 1 includes a signal generation circuit 2, a DA converter 3A, a DA converter 3B, an up-converter 4A, an up-converter 4B, and an analog amplifier circuit 5. The signal generation circuit 2 is a circuit that distributes the input signal, which is a digital signal, into the first signal and the second signal by generating the first signal and the second signal, which are two digital signals, using one input signal, which is the digital signal. Note that, the input signal includes digital information indicating transmission contents and information regarding the carrier frequency. The signal generation circuit 2 includes a digital signal acquiring unit 21, a signal generation unit 22, and a signal distribution unit 23.

The digital signal acquiring unit 21 acquires the input signal, which is the digital signal. The signal generation unit 22 generates an in-phase signal serving as a reference, an orthogonal signal serving as a reference, and an envelope signal serving as a reference by using the input signal acquired by the digital signal acquiring unit 21. The in-phase signal, the orthogonal signal, and the envelope signal are output to the signal distribution unit 23. The signal distribution unit 23 generates the first signal and the second signal by using the in-phase signal, the orthogonal signal, and the envelope signal, a differential value of a function representing either or both an amplitude ratio therebetween and a phase difference therebetween being continuous during transition of the envelope signal from a minimum value to a maximum value.

The DA converter 3A is a first digital-to-analog converter that receives an input of the first signal from the signal distribution unit 23 via an optical transmission path and converts the first signal into an analog signal. The first signal converted into the analog signal is output to the up-converter 4A. The DA converter 3B is a second digital-to-analog converter that receives an input of the second signal from the signal distribution unit 23 via an optical transmission path and converts the second signal into an analog signal. The second signal converted into the analog signal is output to the up-converter 4B.

The up-converter 4A is a first up-converter that generates the first transmission signal Tₓ₁ obtained by up-converting the frequency of the first signal converted into the analog signal by the DA converter 3A to a predetermined carrier frequency. The first transmission signal Tₓ₁ generated by the up-converter 4A is output to the analog amplifier circuit 5. The up-converter 4B is a second up-converter that generates the second transmission signal Tₓ₂ obtained by up-converting the frequency of the second signal converted into the analog signal by the DA converter 3B to a predetermined carrier frequency. The second transmission signal Tₓ₂ generated by the up-converter 4B is output to the analog amplifier circuit 5.

The analog amplifier circuit 5 amplifies the first transmission signal Tₓ₁, amplifies the second transmission signal Tₓ₂, and outputs the output signal obtained by combining the first transmission signal Tₓ₁ and the second transmission signal Tₓ₂. As illustrated in FIG. 1, the analog amplifier circuit 5 includes a first amplifier element 51, a second amplifier element 52, and an output combination circuit 53. The first amplifier element 51 amplifies the first transmission signal Tₓ₁ and outputs the amplified first transmission signal Tₓ₁ to the output combination circuit 53. The second amplifier element 52 amplifies the second transmission signal Tₓ₂ and outputs the amplified second transmission signal Tₓ₂ to the output combination circuit 53.

The output combination circuit 53 outputs, from an output terminal, the signal obtained by combining the first transmission signal Tₓ₁ amplified by the first amplifier element 51 and the second transmission signal Tₓ₂ amplified by the second amplifier element 52. The output combination circuit 53 includes a transmission line 531 and a transmission line 532. The transmission line 531 is a first transmission line that transmits the first transmission signal Tₓ₁ amplified by the first amplifier element 51 to the output terminal. A characteristic impedance of the transmission line 531 is larger than output resistance of the first amplifier element 51.

The transmission line 532 is a second transmission line that transmits the second transmission signal Tₓ₂ amplified by the second amplifier element 52 to the output terminal. The first transmission signal Tₓ₁ and second transmission signal Tₓ₂ are combined at the output terminal to be output. A characteristic impedance of the transmission line 532 is larger than output resistance of the second amplifier element 52.

The output combination circuit 53 plays a role of implementing a load modulation operation as a Doherty amplifier and an out-phasing amplifier in order to implement high efficiency in a back-off operation of the amplifier 1. In the output combination circuit 53, different load modulation operations are implemented by the characteristic impedance and an electric length of the transmission line 531 and the transmission line 532 and a bias class of the first amplifier element 51 and the second amplifier element 52. That is, the amplifier 1 can operate as the Doherty amplifier and the out-phasing amplifier by a combination of the characteristic impedance and the electric length, and the bias class.

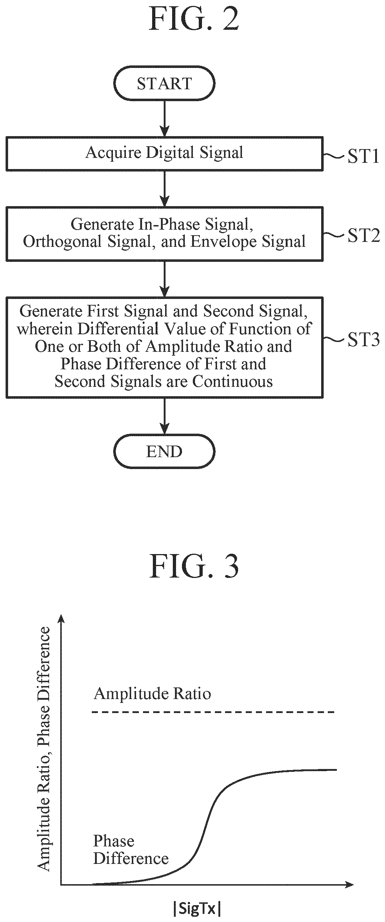

FIG. 2 is a flowchart illustrating a signal distribution method according to the first embodiment, and illustrates an operation of the signal generation circuit 2. The digital signal acquiring unit 21 first acquires the input signal, which is the digital signal (step ST1). The signal generation unit 22 next generates the in-phase signal serving as the reference, the orthogonal signal serving as the reference, and the envelope signal serving as the reference by using the input signal (step ST2). The signal distribution unit 23 subsequently generates the first signal and the second signal by using the in-phase signal, the orthogonal signal, the differential value of the function representing either or both the amplitude ratio therebetween and the phase difference therebetween being continuous during the transition of the envelope signal from the minimum value to the maximum value, and the envelope signal generated by the signal generation unit 22 (step ST3). The first signal is output from the signal distribution unit 23 to the DA converter 3A, and the second signal is output from the signal distribution unit 23 to the DA converter 3B.

The output combination circuit 53 switches between a first signal mode in which the first transmission signal Tₓ₁ and the second transmission signal Tₓ₂ are combined in phase and a second signal mode in which the first transmission signal Tₓ₁ and the second transmission signal Tₓ₂ are combined out of phase depending on an operation frequency of the amplifier 1. The amplifier 1 is switched to a Doherty operation mode for operating as the Doherty amplifier or an out-phasing operation mode for operating as the out-phasing amplifier depending on the switched signal mode. For example, when the output combination circuit 53 is switched to the first signal mode, the operation mode of the amplifier 1 is switched to the Doherty operation mode. When the output combination circuit 53 is switched to the second signal mode, the operation mode of the amplifier 1 is switched to the out-phasing operation mode.

A case where the amplifier 1 operates as the Doherty amplifier is described.

An efficiency matching load of the first amplifier element 51 and the second amplifier element 52 is supposed to be Ropt. For example, the characteristic impedance of the transmission line 531 is Ropt, and the electric length of the transmission line 531 is 90 + N × 180 degrees at the center frequency of an operation frequency band. The characteristic impedance of the transmission line 532 is Ropt, and the electric length of the transmission line 532 is supposed to be N × 180 degrees at the center frequency of the operation frequency band. The first amplifier element 51 is supposed to be biased to a class B, and the second amplifier element 52 is supposed to be biased to the class B or a class C. N is an integer equal to or larger than 0. The load of the outside as seen from the output terminal of the output combination circuit 53 is supposed to be 1/2 × Ropt.

The back-off operation in the Doherty amplifier is described.

In the amplifier 1, when the second transmission signal Tₓ₂ is sufficiently smaller than the first transmission signal Tₓ₁, no signal is output from the second amplifier element 52. At that time, the load of the second amplifier element 52 is regarded to be open, and the load of the transmission line 532 as seen from the output terminal is open. The output load is subjected to impedance conversion by the transmission line 531, and the load of the transmission line 531 of the output combination circuit 53 as seen from the first amplifier element 51 is 2 × Ropt.

An operation at the time of saturation output in the Doherty amplifier is described.

At the time of saturation output, in a case where magnitudes of the first transmission signal Tₓ₁ and the second transmission signal Tₓ₂ are the same and a phase difference therebetween is 90 degrees, both the first amplifier element 51 and the second amplifier element 52 amplify the signals, and the amplified signals are in-phase combined by the output combination circuit 53. At that time, the load of the output combination circuit 53 as seen from the first amplifier element 51 and the second amplifier element 52 is Ropt. In the amplifier 1, since output power at the time of saturation output is four times as large as that at the time of back-off operation, a high efficiency characteristic is implemented up to back-off of 6 dB.

An operation of the signal distribution unit 23 included in the amplifier 1 that operates as the Doherty amplifier is described.

The signal distribution unit 23 generates the first signal and the second signal by using the in-phase signal, the orthogonal signal, and the envelope signal generated by the signal generation unit 22, the differential value of the function representing either or both the amplitude ratio therebetween and the phase difference therebetween being continuous during the transition of the envelope signal from the minimum value to the maximum value.

For example, following formula (1) expresses an amplitude ratio Power_ratio between the first transmission signal Tₓ₁ and the second transmission signal Tₓ₂, and following formula (2) expresses a phase difference Phase_diff between the first transmission signal Tₓ₁ and the second transmission signal Tₓ₂. The signal distribution unit 23 determines the amplitude ratio Power_ratio by following formula (1) and determines the phase difference Phase_diff by following formula (2) depending on the magnitude of the envelope signal. Note that, in following formulae (1) and (2), P_{in_1} represents amplitude of the first transmission signal Tₓ₁, and P_{in_2} represents amplitude of the second transmission signal Tₓ₂. Note that θ₁ represents a phase of the first transmission signal Tₓ₁, and θ₂ is a phase of the second transmission signal Tₓ₂. $Power_ratio = {P}_{in_ 1} / \left({P}_{in_ 1}+{P}_{in_ 2}\right)$ (1) $Phase_diff = {θ}_{1} - {θ}_{2}$ (2)

FIG. 3 is a characteristic diagram illustrating a relationship of the amplitude ratio and the phase difference between the first transmission signal Tₓ₁ and the second transmission signal Tₓ₂ with respect to magnitude |SigTx| of the envelope signal in a first Doherty operation mode, and illustrates a case where the operation mode of the amplifier 1 is the first Doherty operation mode. As illustrated in FIG. 3, the first Doherty operation mode is an operation mode in which the amplitude P_{in_1} of the first transmission signal Tₓ₁ is larger than the amplitude P_{in_2} of the second transmission signal Tₓ₂, the amplitude ratio Power_ratio calculated by the above formula (1) increases as the envelope signal increases, and the phase difference between the phase θ₁ of the first transmission signal Tₓ₁ and the phase θ₂ of the second transmission signal Tₓ₂ is constant.

In a case where the amplifier 1 operates in the first Doherty operation mode, the signal distribution unit 23 generates the first signal and the second signal in such a manner that the amplitude ratio Power_ratio is small when the magnitude |SigTx| of the envelope signal is small, the amplitude ratio Power_ratio asymptotically approaches 0.5 as the magnitude |SigTx| of the envelope signal is larger, and the phase difference Phase_diff is constant regardless of the magnitude |SigTx| of the envelope signal. In a case where the amplifier 1 operates in the first Doherty operation mode, the first amplifier element 51 functions as a main amplifier, and the second amplifier element 52 functions as an auxiliary amplifier. The first transmission signal Tₓ₁ input to the first amplifier element 51, which is the main amplifier, and the second transmission signal Tₓ₂ input to the second amplifier element 52, which is the auxiliary amplifier, have substantially the same power.

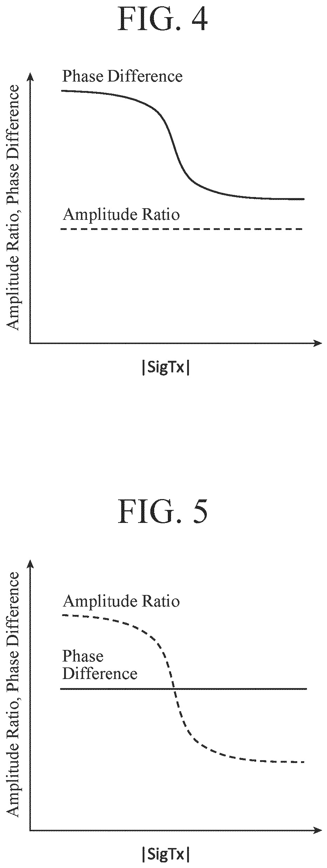

FIG. 4 is a characteristic diagram illustrating a relationship of the amplitude ratio and the phase difference between the first transmission signal Tₓ₁ and the second transmission signal Tₓ₂ with respect to the magnitude |SigTx| of the envelope signal in a second Doherty operation mode, and illustrates a case where the operation mode of the amplifier 1 is the second Doherty operation mode. In the second Doherty operation mode, the characteristic impedance of the transmission line 531 is Ropt, and the electric length of the transmission line 531 is N × 180 degrees at the center frequency of the operation frequency band. The characteristic impedance of the transmission line 532 is Ropt, and the electric length of the transmission line 532 is 90 + N × 180 degrees at the center frequency of the operation frequency band. The first amplifier element 51 is biased to the class B or the class C, and the second amplifier element 52 is biased to the class B. In this case, the first amplifier element 51 functions as the auxiliary amplifier, and the second amplifier element 52 functions as the main amplifier.

As illustrated in FIG. 4, the second Doherty operation mode is an operation mode in which the amplitude P_{in_1} of the first transmission signal Tₓ₁ is larger than the amplitude P_{in_2} of the second transmission signal Tₓ₂, the amplitude ratio Power_ratio calculated by the above formula (1) decreases as the envelope signal increases, and the phase difference between the phase θ₁ of the first transmission signal Tₓ₁ and the phase θ₂ of the second transmission signal Tₓ₂ is constant. In a case where the amplifier 1 operates in the second Doherty operation mode, the signal distribution unit 23 generates the first signal and the second signal in such a manner that the amplitude ratio Power_ratio is close to 0 when the magnitude |SigTx| of the envelope signal is small, the amplitude ratio Power_ratio asymptotically approaches 0.5 as the magnitude |SigTx| of the envelope signal is larger, and the phase difference Phase_diff is constant regardless of the magnitude |SigTx| of the envelope signal.

A case where the amplifier 1 operates as the out-phasing amplifier is described.

The characteristic impedance of the transmission line 531 is supposed to be Ropt, and the electric length of the transmission line 531 is 60 + N × 180 degrees at the center frequency of the operation frequency band. The characteristic impedance of the transmission line 532 is Ropt, and the electric length of the transmission line 532 is supposed to be 120 + N × 180 degrees at the center frequency of the operation frequency band. In this case, the output combination circuit 53 is regarded as a Chireix combination circuit, and the load is modulated depending on the phase difference between the first transmission signal Tₓ₁ amplified by the first amplifier element 51 and the second transmission signal Tₓ₂ amplified by the second amplifier element 52.

For example, in a case where the amplitude ratio Power_ratio calculated using the above formula (1) is 1 and the phase difference Phase_diff calculated using the above formula (2) is +120 degrees, the load of the output combination circuit 53 as seen from the first amplifier element 51 and the second amplifier element 52 is 3 × Ropt. In a case where the amplitude ratio Power_ratio is 1 and the phase difference Phase_diff is +60 degrees, the first transmission signal Tₓ₁ amplified by the first amplifier element 51 and the second transmission signal Tₓ₂ amplified by the second amplifier element 52 are in-phase combined by the output combination circuit 53. The load of the output combination circuit 53 as seen from the first amplifier element 51 and the second amplifier element 52 is Ropt. At that time, the load modulated at the time of back-off operation is three times greater than the load modulated at the time of saturation output, and a high-efficiency operation can be performed.

FIG. 5 is a characteristic diagram illustrating a relationship of the amplitude ratio and the phase difference between the first transmission signal Tₓ₁ and the second transmission signal Tₓ₂ with respect to the magnitude |SigTx| of the envelope signal in a first out-phasing operation mode. FIG. 5 illustrates a case where the operation mode of the amplifier 1 is the first out-phasing operation mode. As illustrated in FIG. 5, the first out-phasing operation mode is an operation mode in which the amplitude ratio Power_ratio calculated by the above formula (1) is constant regardless of the magnitude |SigTx| of the envelope signal, and the phase difference Phase_diff between the phase θ₁ of the first transmission signal Tₓ₁ and the phase θ₂ of the second transmission signal Tₓ₂ decreases as the envelope signal increases. In a case where the amplifier 1 operates in the first out-phasing operation mode, the signal distribution unit 23 generates the first signal and the second signal in such a manner that the amplitude ratio Power_ratio is constant and the phase difference Phase_diff decreases as the magnitude |SigTx| of the envelope signal is larger.

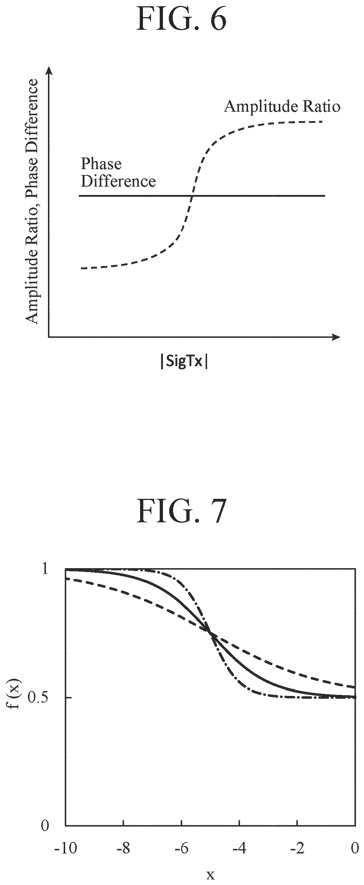

FIG. 6 is a characteristic diagram illustrating a relationship of the amplitude ratio and the phase difference between the first transmission signal Tₓ₁ and the second transmission signal Tₓ₂ with respect to the magnitude |SigTx| of the envelope signal in a second out-phasing operation mode. FIG. 6 illustrates a case where the operation mode of the amplifier 1 is the second out-phasing operation mode. In the second out-phasing operation mode, the characteristic impedance of the transmission line 531 is Ropt, and the electric length of the transmission line 531 is 120 + N × 180 degrees at the center frequency of the operation frequency band. The characteristic impedance of the transmission line 532 is Ropt, and the electric length of the transmission line 532 is 60 + N × 180 degrees at the center frequency of the operation frequency band. In this case, the output combination circuit 53 is regarded as the Chireix combination circuit, and the load is modulated depending on the phase difference between the first transmission signal Tₓ₁ amplified by the first amplifier element 51 and the second transmission signal Tₓ₂ amplified by the second amplifier element 52.

For example, in a case where the amplitude ratio Power_ratio calculated using the above formula (1) is 1 and the phase difference Phase_diff calculated using the above formula (2) is -120 degrees, the load of the output combination circuit 53 as seen from the first amplifier element 51 and the second amplifier element 52 is 3 × Ropt. In a case where the amplitude ratio Power_ratio is 1 and the phase difference Phase_diff is -60 degrees, the first transmission signal Tₓ₁ amplified by the first amplifier element 51 and the second transmission signal Tₓ₂ amplified by the second amplifier element 52 are in-phase combined by the output combination circuit 53. The load of the output combination circuit 53 as seen from the first amplifier element 51 and the second amplifier element 52 is Ropt. At that time, the load modulated at the time of back-off operation is three times greater than the load modulated at the time of saturation output, and a high-efficiency operation can be performed.

As illustrated in FIG. 6, the second out-phasing operation mode is an operation mode in which the amplitude ratio Power_ratio calculated by the above formula (1) is constant regardless of the magnitude |SigTx| of the envelope signal, and the phase difference Phase _diff between the phase θ₁ of the first transmission signal Tₓ₁ and the phase θ₂ of the second transmission signal Tₓ₂ increases as the envelope signal increases. In a case where the amplifier 1 operates in the second out-phasing operation mode, the signal distribution unit 23 generates the first signal and the second signal in such a manner that the amplitude ratio Power_ratio is constant and the phase difference Phase_diff increases as the magnitude |SigTx| of the envelope signal is larger.

As described above, the analog amplifier circuit 5 operates as either the Doherty amplifier or the out-phasing amplifier depending on the characteristics of the transmission line 531 and the transmission line 532.

As illustrated in FIGS. 3 to 6, the Doherty amplifier includes the first Doherty operation mode and the second Doherty operation mode, and the out-phasing amplifier includes the first out-phasing operation mode and the second out-phasing operation mode. The signal distribution unit 23 needs to appropriately control the amplitude ratio and the phase difference between the first transmission signal Tₓ₁ and the second transmission signal Tₓ₂ depending on these operation modes.

A case where the amplitude ratio and the phase difference between the first transmission signal Tₓ₁ and the second transmission signal Tₓ₂ depending on all operation states regarding the first Doherty operation mode, the second Doherty operation mode, the first out-phasing operation mode, and the second out-phasing operation mode are set by an LUT is described as an example. In this case, it is necessary to prepare resolution (the number of bits) necessary for implementing the high efficiency characteristic with respect to the magnitude |SigTx| of the envelope signal, and there is a problem that the LUT is large-scaled.

Therefore, in the amplifier 1, either or both the amplitude ratio and the phase difference between the first transmission signal Tₓ₁ and the second transmission signal Tₓ₂ are expressed by using, for example, a sigmoid curve. A sigmoid function is expressed by following formula (3). In following formula (3), a, b, c, and d represent coefficients. Note that x is obtained by normalizing the magnitude |SigTx| of the envelope signal serving as the reference with the maximum value of |SigTx|. $f \left(x\right) = \left[a/\left\{{e}^{b \left(x-c\right)}+1\right\}\right] + d$ (3)

FIG. 7 is a diagram illustrating an example (1) of the sigmoid function. In FIG. 7, a curve indicated by a broken line is a sigmoid function curve in which the coefficient b in the above formula (3) is 0.5, a curve indicated by a solid line is a sigmoid function curve in which the coefficient b in the above formula (3) is 1, and a curve indicated by a dashed-dotted line is a sigmoid function curve in which the coefficient b in the above formula (3) is 2. As illustrated in FIG. 7, by changing the coefficient b to 0.5, 1, and 2, an inclination at an inflection point of each curve changes.

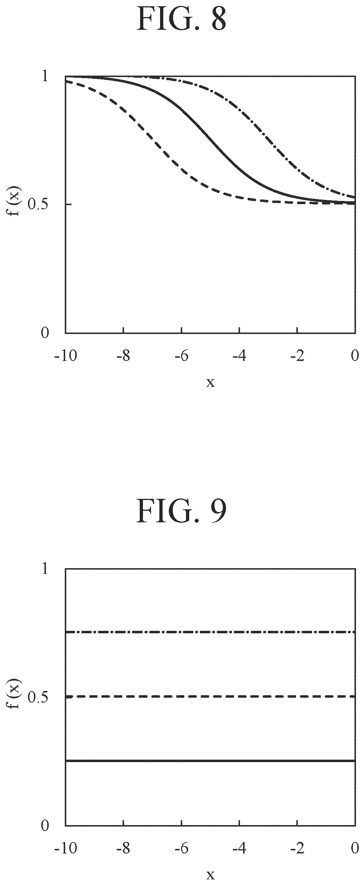

FIG. 8 is a diagram illustrating an example (2) of the sigmoid function. In FIG. 8, a curve indicated by a broken line is a sigmoid function curve in which the coefficient c in the above formula (3) is -3, a curve indicated by a solid line is a sigmoid function curve in which the coefficient c in the above formula (3) is -5, and a curve indicated by a dashed-dotted line is a sigmoid function curve in which the coefficient c in the above formula (3) is -7. As illustrated in FIG. 8, by changing the coefficient c to -3, -5, and -7, an inflection point of each curve changes along a change x-axis.

FIG. 9 is a diagram illustrating an example (3) of the sigmoid function. In FIG. 9, a solid line indicates a sigmoid function value in which the coefficient d in the above formula (3) is 0.25, a broken line indicates a sigmoid function value in which the coefficient d in the above formula (3) is 0.5, and a dashed-dotted line indicates a sigmoid function value in which the coefficient d in the above formula (3) is 0.75. Even when the coefficient d is changed to 0.25, 0.5, and 0.75, the sigmoid function value has no dependency on x and is a constant value.

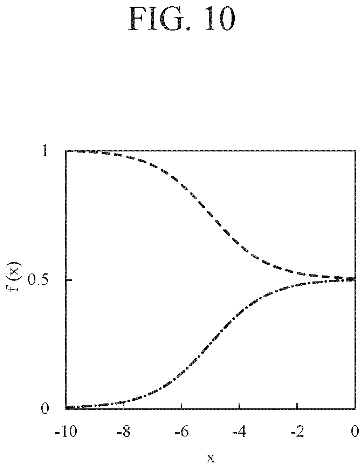

FIG. 10 is a diagram illustrating an example (4) of the sigmoid function. In FIG. 10, a curve indicated by a broken line is a sigmoid function curve in which the coefficient b in the above formula (3) is -1, and a curve indicated by a solid line is a sigmoid function curve in which the coefficient b in the above formula (3) is 1. As illustrated in FIG. 10, by changing the coefficient b to -1 and 1, positive/negative of an inclination at an inflection point of each curve changes.

As illustrated in FIGS. 7 to 10, the amplitude ratio and the phase difference between the first transmission signal Tₓ₁ and the second transmission signal Tₓ₂ illustrated in FIGS. 3 to 6 can be expressed by appropriately setting the coefficients a, b, c, and d of the sigmoid function expressed by the above formula (3). That is, either or both the amplitude ratio and the phase difference between the first transmission signal Tₓ₁ and the second transmission signal Tₓ₂ can be expressed by using the sigmoid function.

The signal distribution unit 23 generates the first signal and the second signal, the differential value (the inclination at the inflection point) of the sigmoid function expressed by the above formula (3) being continuous during transition of the magnitude |SigTx| of the envelope signal from the minimum value (-10 in FIGS. 7 to 10) to the maximum value (0 in FIGS. 7 to 10) by appropriately setting the values of the coefficients a, b, c, and d.

In this manner, the amplifier 1 can determine the amplitude ratio and the phase difference between the first transmission signal Tₓ₁ and the second transmission signal Tₓ₂ corresponding to the first Doherty operation mode, the second Doherty operation mode, the first out-phasing operation mode, and the second out-phasing operation mode by appropriately setting the coefficients a, b, c, and d of the sigmoid function. As a result, the amplifier 1 does not require the LUT having multi-bit resolution or a memory.

For example, in a case where the amplifier 1 is operated in the first Doherty operation mode illustrated in FIG. 3, the coefficient b that determines the amplitude ratio between the first transmission signal Tₓ₁ and the second transmission signal Tₓ₂ is a value larger than 0 (b > 0). Furthermore, in a case where the amplifier 1 is operated in the second Doherty operation mode illustrated in FIG. 4, the coefficient b that determines the amplitude ratio between the first transmission signal Tₓ₁ and the second transmission signal Tₓ₂ is a value smaller than 0 (b < 0).

For example, in a case where the amplifier 1 is operated in the first out-phasing operation mode illustrated in FIG. 5, the coefficient b that determines the phase difference between the first transmission signal Tₓ₁ and the second transmission signal Tₓ₂ is a value smaller than 0 (b < 0). Furthermore, in a case where the amplifier 1 is operated in the second out-phasing operation mode illustrated in FIG. 6, the coefficient b that determines the phase difference between the first transmission signal Tₓ₁ and the second transmission signal Tₓ₂ is a value larger than 0 (b > 0).

A case where the amplitude ratio and the phase difference between the first transmission signal Tₓ₁ and the second transmission signal Tₓ₂ are represented by the sigmoid function is described, but there is no limitation. The function may be a function other than the sigmoid function as long as the differential value of the function representing either or both the amplitude ratio therebetween and the phase difference therebetween being continuous during the transition of the envelope signal as the reference obtained from the input signal from the minimum value to the maximum value.

As described above, in the amplifier 1 according to the first embodiment, it is distributed into the first signal and the second signal, the differential value of the function representing either or both the amplitude ratio therebetween and the phase difference therebetween being continuous during the transition of the envelope signal |SigTx| generated using the input signal from the minimum value to the maximum value, the first amplifier element 51 amplifies the first transmission signal Tₓ₁ based on the first signal, the second amplifier element 52 amplifies the second transmission signal Tₓ₂ based on the second signal, and the amplified first transmission signal Tₓ₁ and the amplified second transmission signal Tₓ₂ are combined to be output. As a result, the amplifier 1 has a circuit configuration smaller than a circuit configuration using the LUT, and can be operated with high efficiency as the Doherty amplifier and the out-phasing amplifier.

The amplifier 1 according to the first embodiment includes the DA converter 3A that converts the first signal into the analog signal, the DA converter 3B that converts the second signal into the analog signal, the up-converter 4A that generates the first transmission signal Tₓ₁ obtained by up-converting the frequency of the first signal, which is the analog signal, into the carrier frequency, and the up-converter 4B that generates the second transmission signal Tₓ₂ obtained by up-converting the frequency of the second signal, which is the analog signal, into the carrier frequency. With these configurations, the amplifier 1 can distribute the first transmission signal Tₓ₁ and the second transmission signal Tₓ₂ to the analog amplifier circuit 5.

In the amplifier 1 according to the first embodiment, the output combination circuit 53 includes the transmission line 531 that transmits the first transmission signal Tₓ₁ amplified by the first amplifier element 51 to the output terminal, and the transmission line 532 that transmits the second transmission signal Tₓ₂ amplified by the second amplifier element 52 to the output terminal. The electric length of the transmission line 531 is 90 + N × 180 degrees at the center frequency of the operation frequency band, and the electric length of the transmission line 532 is N × 180 degrees at the center frequency of the operation frequency band. As a result, the amplifier 1 can be operated in the first Doherty operation mode and the second Doherty operation mode.

In the amplifier 1 according to the first embodiment, the output combination circuit 53 includes the transmission line 531 that transmits the first transmission signal Tₓ₁ amplified by the first amplifier element 51 to the output terminal, and the transmission line 532 that transmits the second transmission signal Tₓ₂ amplified by the second amplifier element 52 to the output terminal. The electric length of the transmission line 531 is 60 + N × 180 degrees at the center frequency of the operation frequency band, and the electric length of the transmission line 532 is 120 + N × 180 degrees at the center frequency of the operation frequency band. As a result, the amplifier 1 can be operated in the first out-phasing operation mode and the second out-phasing operation mode.

In the amplifier 1 according to the first embodiment, the output combination circuit 53 switches between the first signal mode in which the first transmission signal Tₓ₁ and the second transmission signal Tₓ₂ are combined in phase and the second signal mode in which the first transmission signal Tₓ₁ and the second transmission signal Tₓ₂ are combined out of phase depending on the operation frequency, and switches to the Doherty operation mode for operating as the Doherty amplifier or the out-phasing operation mode for operating as the out-phasing amplifier depending on the switched signal mode. As a result, the amplifier 1 can be operated in the Doherty operation mode and the out-phasing operation mode.

In the amplifier 1 according to the first embodiment, the load of the output combination circuit 53 as seen from the first amplifier element 51 is modulated depending on the frequency of the first transmission signal Tₓ₁, and the load of the output combination circuit 53 as seen from the second amplifier element 52 is modulated depending on the frequency of the second transmission signal Tₓ₂. As a result, the amplifier 1 can be operated with high efficiency as the Doherty amplifier and the out-phasing amplifier.

The amplifier 1 according to the first embodiment operates in the first Doherty operation mode in which the amplitude P_{in_1} of the first transmission signal Tₓ₁ is larger than the amplitude P_{in_2} of the second transmission signal Tₓ₂, the ratio Power_ratio of the amplitude P_{in_1} of the first transmission signal Tₓ₁ with respect to the sum of the amplitude P_{in_1} of the first transmission signal Tₓ₁ and the amplitude P_{in_2} of the second transmission signal Tₓ₂ increases as the envelope signal increases, and the phase difference Phase _diff between the phase θ₁ of the first transmission signal Tₓ₁ and the phase θ₂ of the second transmission signal Tₓ₂ is constant. As a result, the amplifier 1 can be operated in the first Doherty operation mode.

The amplifier 1 according to the first embodiment operates in the second Doherty operation mode in which the amplitude P_{in_1} of the first transmission signal Tₓ₁ is larger than the amplitude P_{in_2} of the second transmission signal Tₓ₂, the ratio Power_ratio of the amplitude P_{in_1} of the first transmission signal Tₓ₁ with respect to the sum of the amplitude P_{in_1} of the first transmission signal Tₓ₁ and the amplitude P_{in_2} of the second transmission signal Tₓ₂ decreases as the envelope signal increases, and the phase difference Phase_diff between the phase θ₁ of the first transmission signal Tₓ₁ and the phase θ₂ of the second transmission signal Tₓ₂ is constant. As a result, the amplifier 1 can be operated in the second Doherty operation mode.

The amplifier 1 according to the first embodiment operates in the first out-phasing operation mode in which the amplitude ratio Power_ratio between the amplitude P_{in_1} of the first transmission signal Tₓ₁ and the amplitude P_{in_2} of the second transmission signal Tₓ₂ is constant regardless of the magnitude |SigTx| of the envelope signal, and the phase difference Phase_diff between the phase θ₁ of the first transmission signal Tₓ₁ and the phase θ₂ of the second transmission signal Tₓ₂ decreases as the envelope signal increases. As a result, the amplifier 1 can be operated in the first out-phasing operation mode.

The amplifier 1 according to the first embodiment operates in the second out-phasing operation mode in which the amplitude ratio between the amplitude P_{in_1} of the first transmission signal Tₓ₁ and the amplitude P_{in_2} of the second transmission signal Tₓ₂ is constant regardless of the magnitude |SigTx| of the envelope signal, and the phase difference between the phase θ₁ of the first transmission signal Tₓ₁ and the phase θ₂ of the second transmission signal Tₓ₂ increases as the envelope signal increases. As a result, the amplifier 1 can be operated in the second out-phasing operation mode.

In the amplifier 1 according to the first embodiment, the output combination circuit 53 includes the transmission line 531 that transmits the first transmission signal Tₓ₁ amplified by the first amplifier element 51 to the output terminal, and the transmission line 532 that transmits the second transmission signal Tₓ₂ amplified by the second amplifier element 52 to the output terminal. The characteristic impedance of the transmission line 531 is higher than the output resistance of the first amplifier element 51, and the characteristic impedance of the transmission line 532 is higher than the output resistance of the second amplifier element 52. As a result, the amplifier 1 can be operated with high efficiency as the Doherty amplifier and the out-phasing amplifier.

A signal distribution method according to the first embodiment includes steps of acquiring the input signal, which is the digital signal, by the digital signal acquiring unit 21, generating the in-phase signal, the orthogonal signal, and the envelope signal by using the input signal by the signal generation unit 22, and generating the first signal and the second signal, the differential value of the function representing either or both the amplitude ratio therebetween and the phase difference therebetween being continuous during the transition of the envelope signal from the minimum value to the maximum value using the in-phase signal, the orthogonal signal, and the envelope signal by the signal distribution unit 23. The amplifier 1 that executes the signal distribution method has a circuit configuration smaller than a circuit configuration using the LUT, and can be operated with high efficiency as the Doherty amplifier and the out-phasing amplifier.

### Second Embodiment

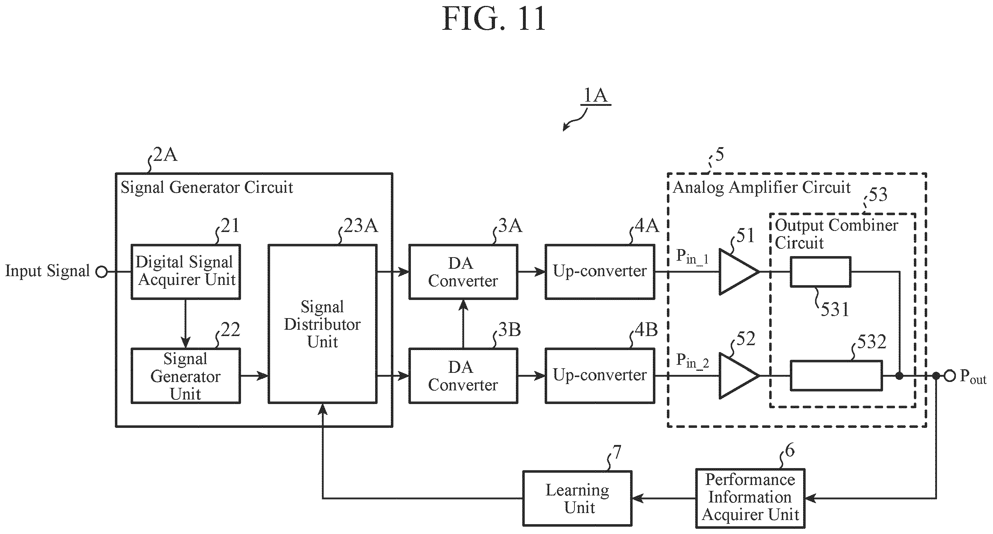

FIG. 11 is a block diagram illustrating a configuration of an amplifier 1A according to a second embodiment. In FIG. 11, the amplifier 1A distributes an input signal into a first signal and a second signal, amplifies a first transmission signal Tₓ₁ obtained by up-converting a frequency of the first signal into a carrier frequency, amplifies a second transmission signal Tₓ₂ obtained by up-converting a frequency of the second signal into a carrier frequency, and outputs an output signal obtained by combining the first transmission signal Tₓ₁ and the second transmission signal Tₓ₂.

The amplifier 1A includes a signal generation circuit 2A, a DA converter 3A, a DA converter 3B, an up-converter 4A, an up-converter 4B, an analog amplifier circuit 5, a performance information acquiring unit 6, and a learning unit 7. The signal generation circuit 2A is a circuit that distributes the input signal, which is a digital signal, into the first signal and the second signal by generating the first signal and the second signal, which are two digital signals, using one input signal, which is the digital signal. Note that the input signal includes digital information indicating transmission contents and information regarding the carrier frequency. The signal generation circuit 2A includes a digital signal acquiring unit 21, a signal generation unit 22, and a signal distribution unit 23A.

The performance information acquiring unit 6 acquires performance information that numerically indicates performance of the analog amplifier circuit 5. The performance information is information that numerically indicates at least one of output power, efficiency, gain, or distortion characteristic of the analog amplifier circuit 5. The distortion characteristic of the analog amplifier circuit 5 includes, for example, adjacent channel power ratio (ACPR), error vector amplitude (EVM), and third-order intermodulation (IM3).

The performance information acquiring unit 6 calculates at least one of the output power, the amplification efficiency, the gain, or the distortion characteristic of the analog amplifier circuit 5 by using a part of the signal output from the analog amplifier circuit 5, and further calculates a difference between these performance and target values. For example, the performance information acquiring unit 6 calculates a value of a cost function cost represented by following formula (4) as the performance information indicating output power Pₒᵤₜ, drain efficiency DE, and the ACPR of the analog amplifier circuit 5. In following formula (4), P_{out_target}, DE_{target}, and ACPR_{target} are values representing target performance of the output power Pₒᵤₜ, the drain efficiency DE, and the ACPR, respectively. C_{Pout}, C_{DE}, and C_{ACPR} represent optional coefficients for the output power Pₒᵤₜ, the drain efficiency DE, and the ACPR, respectively. $cost = - \left[\begin{matrix}{C}_{Pout} \left({P}_{out}/{P}_{out_target}\right) + {C}_{DE} \left(DE/{DE}_{target}\right) + \\ {C}_{ACPR} \left(\left|ACPR\right|/\left|{ACPR}_{target}\right|\right)\end{matrix}\right]$ (4)

As the cost function value calculated using the above formula (4) is smaller, it means that the performance of the analog amplifier circuit 5 is closer to the target value, that is, the operation is closer to the desired performance. Note that the above formula (4) is an example, and a cost function regarding the performance of the analog amplifier circuit 5 other than the output power Pₒᵤₜ, the drain efficiency DE, and the ACPR may be used.

The learning unit 7 updates a value of a coefficient indicating an inclination and an inflection point of a function representing either or both an amplitude ratio and a phase difference between the first signal and the second signal using the performance information. For example, in a case where a sigmoid function is used as the function representing either or both the amplitude ratio and the phase difference between the first signal and the second signal, coefficients indicating the inclination and the inflection point of the function are coefficients a, b, c, and d in the above formula (3). The learning unit 7 updates the values of the coefficients a, b, c, and d in such a manner that the input cost function value becomes smaller by using a learned model that outputs the coefficients a, b, c, and d when the cost function value is input. The learning unit 7 repeats updating the coefficients a, b, c, and d until the cost function value is minimized. As a result, the values of the coefficients a, b, c, and d that maximize the performance of the analog amplifier circuit 5 are obtained.

The values of the coefficients a, b, c, and d updated by the learning unit 7 are output to the signal distribution unit 23A. The signal distribution unit 23A generates the first signal and the second signal using the values of the coefficients a, b, c, and d updated in such a manner as to maximize the performance of the analog amplifier circuit 5. The signal distribution unit 23 may independently determine the amplitude ratio and the phase difference between the first signal and the second signal.

As described above, the amplifier 1A according to the second embodiment includes the performance information acquiring unit 6 that acquires the performance information numerically indicating the performance of the analog amplifier circuit 5, and the learning unit 7 that updates the value of the coefficient indicating the inclination and the inflection point of the function representing either or both the amplitude ratio and the phase difference between the first signal and the second signal using the performance information. The signal distribution unit 23A generates the first signal and the second signal using the coefficient updated by the learning unit 7. As a result, in the signal distribution unit 23A, even in a case where, in the amplifier 1A, the analog amplifier circuit 5 operates as either the Doherty amplifier or the out-phasing amplifier depending on the operation frequency, the amplitude ratio and the phase difference between the first signal and the second signal are optimized by updating the values of the coefficients a, b, c, and d. Therefore, the amplifier 1A can be implemented by a small-scale circuit without necessity of preparing the LUT of the coefficients a, b, c, and d depending on the operation frequency.

### INDUSTRIAL APPLICABILITY

The amplifier according to the present disclosure can be used as, for example, an amplifier for a mobile communication base station.

### REFERENCE SIGNS LIST

1and 1A: Amplifier, 2 and 2A: Signal generation circuit, 3A and 3B: DA converter, 4A and 4B: Up-converter, 5: Analog amplifier circuit, 6: Performance information acquiring unit, 7: Learning unit, 21: Digital signal acquiring unit, 22: Signal generation unit, 23 and 23A: Signal distribution unit, 51: First amplifier element, 52: Second amplifier element, 53: Output combination circuit, 531 and 532: Transmission line

## Claims

1. An amplifier (1, 1A) comprising:
a first amplifier element (51) to amplify a first transmission signal obtained by up-converting a frequency of a first signal into a carrier frequency; a second amplifier element (52) to amplify a second transmission signal obtained by up-converting a frequency of a second signal into a carrier frequency; and an output combination circuit (53) to combine the amplified first transmission signal and the amplified second transmission signal to output,
the amplifier (1, 1A) comprising:
a digital signal acquiring unit (21) to acquire an input signal, which is a digital signal;
a signal generation unit (22) to generate an in-phase signal serving as a reference, an orthogonal signal serving as a reference, and an envelope signal serving as a reference by using the input signal; and
a signal distribution unit (23, 23A) to generate the first signal and the second signal by using the in-phase signal, the orthogonal signal, and the envelope signal, a differential value of a function representing either or both an amplitude ratio therebetween and a phase difference therebetween being continuous during transition of the envelope signal from a minimum value to a maximum value,
**characterised in that**
the function is a sigmoid function expressed by following formula: $f \left(x\right) = \left[a/\left\{{e}^{b \left(x-c\right)}+1\right\}\right] + d$
where f(x) is the sigmoid function, where a, b, c, and d represent coefficients, and where x is obtained by normalizing a magnitude |SigTx| of the envelope signal serving as a reference with a maximum value of |SigTx|.

2. The amplifier (1, 1A) according to claim 1, comprising:
a first digital-to-analog converter (3A) to convert the first signal into an analog signal;
a second digital-to-analog converter (3B) to convert the second signal into an analog signal;
a first up-converter (4A) to generate the first transmission signal obtained by up-converting a frequency of the first signal, which is the analog signal, into the carrier frequency; and
a second up-converter (4B) to generate the second transmission signal obtained by up-converting a frequency of the second signal, which is the analog signal, into the carrier frequency.

3. The amplifier (1A) according to claim 1, comprising:
a performance information acquiring unit (6) to acquire performance information numerically indicating performance of an analog amplifier circuit (5) including the first amplifier element (51), the second amplifier element (52), and the output combination circuit (53); and
a learning unit (7) to update a value of a coefficient indicating an inclination and an inflection point of the function representing either or both the amplitude ratio and the phase difference between the first signal and the second signal by using the performance information, wherein
the signal distribution unit (23A) generates the first signal and the second signal by using the coefficient updated by the learning unit (7).

4. The amplifier (1, 1A) according to claim 1, wherein
the output combination circuit (53) includes a first transmission line (531) to transmit the first transmission signal amplified by the first amplifier element (51) to an output terminal, and a second transmission line (532) to transmit the second transmission signal amplified by the second amplifier element (52) to the output terminal, and
in a case where N is an integer equal to or larger than 0, an electric length of the first transmission line (531) is 90 + N × 180 degrees at a center frequency of an operation frequency band, and an electric length of the second transmission line (532) is N × 180 degrees at the center frequency of the operation frequency band.

5. The amplifier (1, 1A) according to claim 1, wherein
the output combination circuit (53) includes a first transmission line (531) to transmit the first transmission signal amplified by the first amplifier element (51) to an output terminal, and a second transmission line (532) to transmit the second transmission signal amplified by the second amplifier element (52) to the output terminal, and
in a case where N is an integer equal to or larger than 0, an electric length of the first transmission line (531) is 60 + N × 180 degrees at a center frequency of an operation frequency band, and an electric length of the second transmission line (532) is 120 + N × 180 degrees at the center frequency of the operation frequency band.

6. The amplifier (1, 1A) according to claim 4 or 5, wherein
the output combination circuit (53) switches between a first signal mode in which the first transmission signal and the second transmission signal are combined in phase and a second signal mode in which the first transmission signal and the second transmission signal are combined out of phase depending on an operation frequency, and switches to a Doherty operation mode for operating as a Doherty amplifier or an out-phasing operation mode for operating as an out-phasing amplifier depending on the switched signal mode.

7. The amplifier (1, 1A) according to claim 4 or 5, wherein
a load of the output combination circuit (53) as seen from the first amplifier element (51) is modulated depending on the frequency of the first transmission signal, and
a load of the output combination circuit (53) as seen from the second amplifier element (52) is modulated depending on the frequency of the second transmission signal.

8. The amplifier (1, 1A) according to claim 6, which operates in a first Doherty operation mode in which an amplitude of the first transmission signal is larger than an amplitude of the second transmission signal, a ratio of the amplitude of the first transmission signal to a sum of the amplitude of the first transmission signal and the amplitude of the second transmission signal increases as the envelope signal increases, and a phase difference between a phase of the first transmission signal and a phase of the second transmission signal is constant.

9. The amplifier (1, 1A) according to claim 6, which operates in a second Doherty operation mode in which an amplitude of the first transmission signal is larger than an amplitude of the second transmission signal, a ratio of the amplitude of the first transmission signal to a sum of the amplitude of the first transmission signal and the amplitude of the second transmission signal decreases as the envelope signal increases, and a phase difference between a phase of the first transmission signal and a phase of the second transmission signal is constant.

10. The amplifier (1, 1A) according to claim 6, which operates in a first out-phasing operation mode in which an amplitude ratio between an amplitude of the first transmission signal and an amplitude of the second transmission signal is constant regardless of magnitude of the envelope signal, and a phase difference between a phase of the first transmission signal and a phase of the second transmission signal decreases as the envelope signal increases.

11. The amplifier (1, 1A) according to claim 6, which operates in a second out-phasing operation mode in which an amplitude ratio between an amplitude of the first transmission signal and an amplitude of the second transmission signal is constant regardless of magnitude of the envelope signal, and a phase difference between a phase of the first transmission signal and a phase of the second transmission signal increases as the envelope signal increases.

12. The amplifier (1, 1A) according to claim 1, wherein
the output combination circuit (53) includes a first transmission line (531) to transmit the first transmission signal amplified by the first amplifier element (51) to an output terminal, and a second transmission line (532) to transmit the second transmission signal amplified by the second amplifier element (52) to the output terminal,
a characteristic impedance of the first transmission line (531) is higher than output resistance of the first amplifier element (51), and
a characteristic impedance of the second transmission line (532) is higher than output resistance of the second amplifier element (52).

13. A signal distribution method of an amplifier (1, 1A) including: a first amplifier element (51) to amplify a first transmission signal obtained by up-converting a frequency of a first signal into a carrier frequency; a second amplifier element (52) to amplify a second transmission signal obtained by up-converting a frequency of a second signal into a carrier frequency; and an output combination circuit (53) to combine the amplified first transmission signal and the amplified second transmission signal to output,
the signal distribution method comprising steps of:
acquiring an input signal, which is a digital signal, by a digital signal acquiring unit (21);
generating an in-phase signal serving as a reference, an orthogonal signal serving as a reference, and an envelope signal serving as a reference by using the input signal by a signal generation unit (22); and
generating the first signal and the second signal, a differential value of a function representing either or both an amplitude ratio therebetween and a phase difference therebetween is continuous during transition of the envelope signal from a minimum value to a maximum value using the in-phase signal, the orthogonal signal, and the envelope signal by a signal distribution unit (23, 23A),
**characterised in that**
the function is a sigmoid function expressed by following formula: $f \left(x\right) = \left[a/\left\{{e}^{b \left(x-c\right)}+1\right\}\right] + d$
where f(x) is the sigmoid function, where a, b, c, and d represent coefficients, and where x is obtained by normalizing a magnitude |SigTx| of the envelope signal serving as a reference with a maximum value of |SigTx|.

## Patentansprüche

1. Verstärker (1, 1A), umfassend:
ein erstes Verstärkerelement (51) zum Verstärken eines ersten Übertragungssignals, das durch Aufwärtswandeln einer Frequenz eines ersten Signals in eine Trägerfrequenz gewonnen wird; ein zweites Verstärkerelement (52) zum Verstärken eines zweiten Sendesignals, das durch Aufwärtswandeln einer Frequenz eines zweiten Signals in eine Trägerfrequenz erhalten wird; und eine Ausgangskombinationsschaltung (53) zum Kombinieren des verstärkten ersten Sendesignals und des verstärkten zweiten Sendesignals zur Ausgabe,
wobei der Verstärker (1, 1A), umfasst:
eine digitale Signalbeschaffungseinheit (21) zum Beschaffen eines Eingangssignals, das ein digitales Signal ist;
eine Signalerzeugungseinheit (22) zum Erzeugen eines als Referenz dienenden In-Phase-Signals, eines als Referenz dienenden orthogonalen Signals und eines als Referenz dienenden Hüllkurvensignals unter Verwendung des Eingangssignals; und
eine Signalverteilungseinheit (23, 23A) zum Erzeugen des ersten Signals und des zweiten Signals unter Verwendung des In-Phase-Signals, des orthogonalen Signals und des Hüllkurvensignals, wobei ein Differenzwert einer Funktion, die entweder ein Amplitudenverhältnis zwischen diesen oder eine Phasendifferenz zwischen diesen oder beides darstellt, während eines Übergangs des Hüllkurvensignals von einem Minimalwert zu einem Maximalwert kontinuierlich ist,
**dadurch gekennzeichnet, dass**
die Funktion eine Sigmoidfunktion ist, die durch die folgende Formel ausgedrückt wird: $f \left(x\right) = \left[a/\left\{{e}^{b \left(x-c\right)}+1\right\}\right] + d$
wobei f(x) die Sigmoidfunktion ist, wobei a, b, c und d Koeffizienten darstellen und wobei x durch Normalisierung eines Betrags |SigTx| des als Referenz dienenden Hüllkurvensignals mit einem Maximalwert von |SigTx| erhalten wird.

2. Verstärker (1, 1A) nach Anspruch 1, umfassend:
einen ersten Digital-zu-Analog-Wandler (3A) zum Umwandeln des ersten Signals in ein analoges Signal;
einen zweiten Digital-zu-Analog-Wandler (3B) zum Umwandeln des zweiten Signals in ein analoges Signal;
einen ersten Aufwärtswandler (4A) zum Erzeugen des ersten Übertragungssignals, das durch Aufwärtswandeln einer Frequenz des ersten Signals, bei dem es sich um das analoge Signal handelt, in die Trägerfrequenz erhalten wird; und
einen zweiten Aufwärtswandler (4B) zum Erzeugen des zweiten Übertragungssignals, das durch Aufwärtswandeln einer Frequenz des zweiten Signals, bei dem es sich um das analoge Signal handelt, in die Trägerfrequenz erhalten wird.

3. Verstärker (1A) nach Anspruch 1, umfassend:
eine Güteinformation-Beschaffungseinheit (6) zum Beschaffen von Güteinformation, die eine Güte einer analogen Verstärkerschaltung (5), die das erste Verstärkerelement (51), das zweite Verstärkerelement (52) und die Ausgangskombinationsschaltung (53) enthält, numerisch angeben; und
eine Lerneinheit (7) zum Aktualisieren eines Wertes eines Koeffizienten, der eine Steigung und einen Wendepunkt der Funktion angibt, die entweder das Amplitudenverhältnis oder die Phasendifferenz oder beides zwischen dem ersten Signal und dem zweiten Signal darstellt, unter Verwendung der Güteinformation, wobei
die Signalverteilungseinheit (23A) das erste Signal und das zweite Signal unter Verwendung des von der Lerneinheit (7) aktualisierten Koeffizienten erzeugt.

4. Verstärker (1, 1A) nach Anspruch 1, wobei
die Ausgangskombinationsschaltung (53) eine erste Übertragungsleitung (531) zum Übertragen des durch das erste Verstärkerelement (51) verstärkten ersten Übertragungssignals an einen Ausgangsanschluss sowie eine zweite Übertragungsleitung (532) zum Übertragen des durch das zweite Verstärkerelement (52) verstärkten zweiten Übertragungssignals an den Ausgangsanschluss umfasst, und
in einem Fall, in dem N eine ganze Zahl größer oder gleich 0 ist, eine elektrische Länge der ersten Übertragungsleitung (531) 90 + N × 180 Grad bei der Mittenfrequenz eines Betriebsfrequenzbandes beträgt und die elektrische Länge der zweiten Übertragungsleitung (532) beträgt N × 180 Grad bei der Mittenfrequenz des Betriebsfrequenzbandes beträgt.

5. Verstärker (1, 1 A) nach Anspruch 1, wobei
die Ausgangskombinationsschaltung (53) eine erste Übertragungsleitung (531) zum Übertragen des durch das erste Verstärkerelement (51) verstärkten ersten Übertragungssignals an einen Ausgangsanschluss sowie eine zweite Übertragungsleitung (532) zum Übertragen des durch das zweite Verstärkerelement (52) verstärkten zweiten Übertragungssignals an den Ausgangsanschluss umfasst, und
in einem Fall, in dem N eine ganze Zahl größer oder gleich 0 ist, eine elektrische Länge der ersten Übertragungsleitung (531) 60 + N × 180 Grad bei der Mittenfrequenz eines Betriebsfrequenzbandes beträgt und eine elektrische Länge der zweiten Übertragungsleitung (532) 120 + N × 180 Grad bei der Mittenfrequenz des Betriebsfrequenzbandes beträgt.

6. Verstärker (1, 1A) nach Anspruch 4 oder 5, wobei
die Ausgangskombinationsschaltung (53) in Abhängigkeit von einer Betriebsfrequenz zwischen einem ersten Signalmodus, in dem das erste Übertragungssignal und das zweite Übertragungssignal in Phase kombiniert werden, und einem zweiten Signalmodus, in dem das erste Übertragungssignal und das zweite Übertragungssignal außer Phase kombiniert werden, umschaltet, und je nach eingeschaltetem Signalmodus in einen Doherty-Betriebsmodus für den Betrieb als Doherty-Verstärker oder in einen Out-Phasing-Betriebsmodus für den Betrieb als Out-Phasing-Verstärker schaltet.

7. Verstärker (1, 1A) nach Anspruch 4 oder 5, wobei
eine Last der Ausgangskombinationsschaltung (53) vom ersten Verstärkerelement (51) aus gesehen in Abhängigkeit von der Frequenz des ersten Übertragungssignals moduliert wird und
eine Last der Ausgangskombinationsschaltung (53) vom zweiten Verstärkerelement (52) aus gesehen in Abhängigkeit von der Frequenz des zweiten Übertragungssignals moduliert wird.

8. Verstärker (1, 1A) gemäß Anspruch 6, der in einem ersten Doherty-Betriebsmodus arbeitet, in dem eine Amplitude des ersten Übertragungssignals größer ist als eine Amplitude des zweiten Übertragungssignals, ein Verhältnis der Amplitude des ersten Übertragungssignals zur Summe aus der Amplitude des ersten Übertragungssignals und der Amplitude des zweiten Übertragungssignals mit zunehmendem Hüllkurvensignal zunimmt und eine Phasendifferenz zwischen einer Phase des ersten Übertragungssignals und einer Phase des zweiten Übertragungssignalls konstant ist.

9. Verstärker (1, 1A) gemäß Anspruch 6, der in einem zweiten Doherty-Betriebsmodus arbeitet, in dem eine Amplitude des ersten Übertragungssignals größer ist als eine Amplitude des zweiten Übertragungssignals, ein Verhältnis der Amplitude des ersten Übertragungssignals zur Summe aus der Amplitude des ersten Übertragungssignals und der Amplitude des zweiten Übertragungssignals mit zunehmendem Hüllkurvensignal abnimmt und eine Phasendifferenz zwischen einer Phase des ersten Übertragungssignals und einer Phase des zweiten Übertragungssignalls konstant ist.

10. Verstärker (1, 1A) gemäß Anspruch 6, der in einem ersten Out-Phasing-Betriebsmodus arbeitet, in dem ein Amplitudenverhältnis zwischen einer Amplitude des ersten Übertragungssignals und einer Amplitude des zweiten Übertragungssignals unabhängig von einer Größe des Hüllkurvensignals konstant ist und eine Phasendifferenz zwischen einer Phase des ersten Übertragungssignals und einer Phase des zweiten Übertragungssignals mit zunehmendem Hüllkurvensignal abnimmt.

11. Verstärker (1, 1A) nach Anspruch 6, der in einem zweiten Out-Phasing-Betriebsmodus arbeitet, in dem ein Amplitudenverhältnis zwischen einer Amplitude des ersten Übertragungssignals und einer Amplitude des zweiten Übertragungssignals unabhängig von einer Größe des Hüllkurvensignals konstant ist und eine Phasendifferenz zwischen einer Phase des ersten Übertragungssignals und einer Phase des zweiten Übertragungssignals mit zunehmendem Hüllkurvensignal zunimmt.

12. Verstärker (1, 1A) nach Anspruch 1, wobei
die Ausgangskombinationsschaltung (53) eine erste Übertragungsleitung (531) zum Übertragen des durch das erste Verstärkerelement (51) verstärkten ersten Übertragungssignals an einen Ausgangsanschluss sowie eine zweite Übertragungsleitung (532) zum Übertragen des durch das zweite Verstärkerelement (52) verstärkten zweiten Übertragungssignals an den Ausgangsanschluss umfasst,
eine charakteristische Impedanz der ersten Übertragungsleitung (531) höher als ein Ausgangswiderstand des ersten Verstärkerelements (51) ist, und
eine charakteristische Impedanz der zweiten Übertragungsleitung (532) höher als ein Ausgangswiderstand des zweiten Verstärkerelements (52) ist.

13. Signalverteilungsverfahren eines Verstärkers (1, 1A), umfassend: ein erstes Verstärkerelement (51) zum Verstärken eines ersten Sendesignals, das durch Aufwärtswandeln einer Frequenz eines ersten Signals in eine Trägerfrequenz erhalten wird; ein zweites Verstärkerelement (52) zum Verstärken eines zweiten Sendesignals, das durch Aufwärtswandeln einer Frequenz eines zweiten Signals in eine Trägerfrequenz erhalten wird; und eine Ausgangskombinationsschaltung (53) zum Kombinieren des verstärkten ersten Übertragungssignals und des verstärkten zweiten Übertragungssignals zur Ausgabe,
wobei das Signalverteilungsverfahren die folgenden Schritte umfasst:
Beschaffen eines Eingangssignals, bei dem es sich um ein digitales Signal handelt, durch eine digitale Signalbeschaffungseinheit (21);
Erzeugen eines als Referenz dienenden In-Phase-Signals, eines als Referenz dienenden orthogonalen Signals und eines als Referenz dienenden Hüllkurvensignals unter Verwendung des Eingangssignals durch eine Signalerzeugungseinheit (22); und
Erzeugen des ersten Signals und des zweiten Signals, wobei ein Differenzwert einer Funktion, der entweder ein Amplitudenverhältnis zwischen diesen beiden Signalen oder eine Phasendifferenz zwischen diesen beiden Signalen oder beides darstellt, während des Übergangs des Hüllkurvensignals von einem Minimalwert zu einem Maximalwert unter Verwendung des In-Phase-Signals, des orthogonalen Signals und des Hüllkurvensignals durch eine Signalverteilungseinheit (23, 23A) kontinuierlich ist,
**dadurch gekennzeichnet, dass**
die Funktion eine Sigmoidfunktion ist, die durch die folgende Formel ausgedrückt wird: $f \left(x\right) = \left[a/\left\{{e}^{b \left(x-c\right)}+1\right\}\right] + d$
wobei f(x) die Sigmoidfunktion ist, wobei a, b, c und d Koeffizienten darstellen und wobei x durch Normalisierung eines Betrags |SigTx| des als Referenz dienenden Hüllkurvensignals mit einem Maximalwert von |SigTx| erhalten wird.

## Revendications

1. Un amplificateur (1, 1A) comprenant :
un premier élément amplificateur (51) pour amplifier un premier signal de transmission obtenu par élévation de fréquence d'un premier signal en une fréquence porteuse ; un deuxième élément amplificateur (52) pour amplifier un deuxième signal de transmission obtenu par élévation de fréquence d'un deuxième signal en une fréquence porteuse ; et un circuit de sortie de combinaison (53) pour combiner le premier signal de transmission amplifié et le deuxième signal de transmission amplifié pour délivrer en sortie,
l'amplificateur (1, 1A) comprenant :
une unité d'acquisition de signal numérique (21) pour acquérir un signal d'entrée, qui est un signal numérique ;
une unité de génération de signal (22) pour générer un signal en phase servant de référence, un signal orthogonal servant de référence, et un signal d'enveloppe servant de référence en utilisant le signal d'entrée ; et
une unité de distribution de signal (23, 23A) pour générer le premier signal et le deuxième signal en utilisant le signal en phase, le signal orthogonal, et le signal d'enveloppe, une valeur différentielle d'une fonction représentant l'un ou l'autre ou les deux parmi un rapport d'amplitude entre eux et une différence de phase entre eux étant continue pendant une transition du signal d'enveloppe d'une valeur minimale à une valeur maximale,
**caractérisé en ce que**
la fonction est une fonction sigmoïde exprimée par la formule suivante : $f \left(x\right) = \left[a/\left\{{e}^{b \left(x-c\right)}+1\right\}\right] + d$
où f(x) est la fonction sigmoïde, où a, b, c et d représentent des coefficients, et où x est obtenu en normalisant une grandeur |SigTx| du signal d'enveloppe servant de référence avec une valeur maximale de |SigTx|.

2. L'amplificateur (1, 1A) selon la revendication 1, comprenant :
un premier convertisseur numérique-analogique (3A) pour convertir le premier signal en un signal analogique ;
un deuxième convertisseur numérique-analogique (3B) pour convertir le deuxième signal en un signal analogique ;
un premier convertisseur élévateur (4A) pour générer le premier signal de transmission obtenu par élévation d'une fréquence du premier signal, qui est le signal analogique, à la fréquence porteuse ; et
un deuxième convertisseur élévateur (4B) pour générer le deuxième signal de transmission obtenu par élévation d'une fréquence du deuxième signal, qui est le signal analogique, à la fréquence porteuse.

3. L'amplificateur (1A) selon la revendication 1, comprenant :
une unité d'acquisition d'informations de performance (6) pour acquérir des informations de performance indiquant numériquement la performance d'un circuit amplificateur analogique (5) incluant le premier élément amplificateur (51), le deuxième élément amplificateur (52), et le circuit de combinaison de sortie (53) ; et
une unité d'apprentissage (7) pour mettre à jour une valeur d'un coefficient indiquant une pente et un point d'inflexion de la fonction représentant l'un ou l'autre ou les deux parmi le rapport d'amplitude et la différence de phase entre le premier signal et le deuxième signal en utilisant les informations de performance, dans lequel
l'unité de distribution de signal (23A) génère le premier signal et le deuxième signal en utilisant le coefficient mis à jour par l'unité d'apprentissage (7).

4. L'amplificateur (1, 1A) selon la revendication 1, dans lequel
le circuit de combinaison de sortie (53) inclut une première ligne de transmission (531) pour transmettre le premier signal de transmission amplifié par le premier élément amplificateur (51) à une borne de sortie, et une deuxième ligne de transmission (532) pour transmettre le deuxième signal de transmission amplifié par le deuxième élément amplificateur (52) à la borne de sortie, et
dans un cas où N est un entier égal ou supérieur à 0, une longueur électrique de la première ligne de transmission (531) est de 90 + N × 180 degrés à une fréquence centrale d'une bande de fréquences de fonctionnement, et une longueur électrique de la deuxième transmission ligne (532) est de N × 180 degrés à la fréquence centrale de la bande de fréquences de fonctionnement.

5. L'amplificateur (1, 1A) selon la revendication 1, dans lequel
le circuit de combinaison de sortie (53) inclut une première ligne de transmission (531) pour transmettre le premier signal de transmission amplifié par le premier élément amplificateur (51) à une borne de sortie, et une deuxième ligne de transmission (532) pour transmettre le deuxième signal de transmission amplifié par le deuxième élément amplificateur (52) à la borne de sortie, et
dans un cas où N est un entier égal ou supérieur à 0, une longueur électrique de la première ligne de transmission (531) est de 60 + N × 180 degrés à une fréquence centrale d'une bande de fréquences de fonctionnement, et une longueur électrique de la deuxième transmission ligne (532) est de 120 + N × 180 degrés à la fréquence centrale de la bande de fréquences de fonctionnement.

6. L'amplificateur (1, 1A) selon la revendication 4 ou 5, dans lequel
le circuit de combinaison de sortie (53) commute entre un premier mode de signal dans lequel le premier signal de transmission et le deuxième signal de transmission sont combinés en phase et un deuxième mode de signal dans lequel le premier signal de transmission et le deuxième signal de transmission sont combinés hors phase en fonction d'une fréquence de fonctionnement, et commute vers un mode de fonctionnement Doherty pour fonctionner comme un amplificateur Doherty ou un mode de fonctionnement out-phasing pour fonctionner comme un amplificateur out-phasing en fonction du mode de signal commuté.

7. L'amplificateur (1, 1A) selon la revendication 4 ou 5, dans lequel
une charge du circuit de combinaison de sortie (53) telle que vue depuis le premier amplificateur élément (51) est modulé en fonction de la fréquence du premier signal de transmission, et
une charge du circuit de combinaison de sortie (53) telle que vue depuis le deuxième élément amplificateur (52) est modulée en fonction de la fréquence du deuxième signal de transmission.

8. L'amplificateur (1, 1A) selon la revendication 6, qui fonctionne dans un premier mode de fonctionnement Doherty dans lequel une amplitude du premier signal de transmission est supérieure à une amplitude du deuxième signal de transmission, un rapport de l'amplitude du premier signal de transmission à une somme de l'amplitude du premier signal de transmission et l'amplitude du deuxième signal de transmission augmente à mesure que le signal d'enveloppe augmente, et une différence de phase entre une phase du premier signal de transmission et une phase du deuxième signal de transmission est constante.

9. L'amplificateur (1, 1A) selon la revendication 6, qui fonctionne dans un deuxième mode de fonctionnement Doherty dans lequel une amplitude du premier signal de transmission est supérieure à une amplitude du deuxième signal de transmission, un rapport de l'amplitude du premier signal de transmission à une somme de l'amplitude du premier signal de transmission et l'amplitude du deuxième signal de transmission diminue à mesure que le signal d'enveloppe augmente, et une différence de phase entre une phase du premier signal de transmission et une phase du deuxième signal de transmission est constante.

10. L'amplificateur (1, 1A) selon la revendication 6, qui fonctionne dans un premier mode de fonctionnement out-phasing dans lequel un rapport d'amplitude entre une amplitude du premier signal de transmission et une amplitude du deuxième signal de transmission est constant indépendamment de la grandeur du signal d'enveloppe, et une différence de phase entre une phase du premier signal de transmission et une phase du deuxième signal de transmission diminue à mesure que le signal d'enveloppe augmente.

11. L'amplificateur (1, 1A) selon la revendication 6, qui fonctionne dans un deuxième mode de fonctionnement out-phasing dans lequel un rapport d'amplitude entre une amplitude du premier signal de transmission et une amplitude du deuxième signal de transmission est constant indépendamment de la grandeur du signal d'enveloppe, et une différence de phase entre une phase du premier signal de transmission et une phase du deuxième signal de transmission augmente à mesure que le signal d'enveloppe augmente.

12. L'amplificateur (1, 1A) selon la revendication 1, dans lequel
dans lequel le circuit de combinaison de sortie (53) comprend une première ligne de transmission (531) pour transmettre le premier signal de transmission amplifié par le premier élément amplificateur (51) à une borne de sortie, et une deuxième ligne de transmission (532) pour transmettre le deuxième signal de transmission amplifié par le deuxième élément amplificateur (52) à la borne de sortie,
une impédance caractéristique de la première ligne de transmission (531) est supérieure à la résistance de sortie du premier élément amplificateur (51), et
une impédance caractéristique de la deuxième ligne de transmission (532) est supérieure à la résistance de sortie du deuxième élément amplificateur (52).

13. Un procédé de distribution de signal d'un amplificateur (1, 1A) comprenant : un premier élément amplificateur (51) pour amplifier un premier signal de transmission obtenu par élévation d'une fréquence d'un premier signal en une fréquence porteuse ; un deuxième amplificateur élément (52) pour amplifier un deuxième signal de transmission obtenu par élévation d'une fréquence d'un deuxième signal en une fréquence porteuse ; et un circuit de combinaison de sortie (53) pour combiner le premier signal de transmission amplifié et le deuxième signal de transmission amplifié pour sortir,
le procédé de distribution de signal comprenant les étapes consistant à :
acquérir un signal d'entrée, qui est un signal numérique, par une unité d'acquisition de signal numérique (21) ;
générer un signal en phase servant de référence, un signal orthogonal servant de référence, et un signal d'enveloppe servant de référence en utilisant le signal d'entrée par une unité de génération de signal (22) ; et
générer le premier signal et le deuxième signal, une valeur différentielle d'une fonction représentant l'un quelconque ou les deux parmi un rapport d'amplitude entre eux et une différence de phase entre eux est continue pendant une transition du signal d'enveloppe depuis une valeur minimale à une valeur maximale en utilisant le signal en phase, le signal orthogonal et le signal d'enveloppe par une unité de distribution de signal (23, 23A),
**caractérisé en ce que**
la fonction est une fonction sigmoïde exprimée par la formule suivante : $f \left(x\right) = \left[a/\left\{{e}^{b \left(x-c\right)}+1\right\}\right] + d$
où f(x) est la fonction sigmoïde, où a, b, c et d représentent des coefficients, et où x est obtenu en normalisant une grandeur |SigTx| du signal d'enveloppe servant de référence avec une valeur maximale de |SigTx|.
